# EUROPEAN PATENT APPLICATION

(11) **EP 3 048 469 A1**
(43) Date of publication of application: **27.07.2016**
(21) Application number: 14845312.9
(22) Date of filing: 12.09.2014
(51) Int. Cl.: G02B 27/01, B60K 35/00, B60K 37/02

(54) **HEAD-UP DISPLAY**

(30) Priority: 17.09.2013 KR 20130112184
(71) Applicant: Neoviewkolon Co., Ltd., Chungcheongnam-do 350-883 (KR)
(72) Inventor: PARK, Chang Won, Seoul 131-817 (KR); LEE, Soo Yeon, Yongin-si Gyeonggi-do 446-797 (KR)
(74) Representative: Merkle, Gebhard
(86) International application number: PCT/KR2014/008516
(87) International publication number: WO 2015/041431

(57) **Abstract**

The present invention provides a head-up display 100 displaying operation information of a transportation means such as an aircraft or a ship, which includes a main body 110; a display unit 130 which is pivotally connected with the main body 110 and displays the operation information of the transportation means as an image; and a mounting unit 150 for mounting the main body 110 in the transportation means. By adjusting an angle between the display unit 130 and the main body 110, a position of the display unit 130 may be adjusted so that a position thereof is within a range of forward view of a driver.

## Description

### [Technical Field]

The present invention relates to a head-up display, and more particularly, to a head-up display which is installed within forward view of a driver driving a transportation means such as a vehicle, etc., to display operation information of the transportation means.

### [Background Art]

A head-up display (HUD) refers to a display device designed to display operation information of a transportation means such as a vehicle, an aircraft, etc., in front of a driver such that a driver driving the vehicle, the aircraft, etc., may visually recognize the operation information without moving gaze. In early stage, the head-up display was introduced to secure forward visibility of an avigator, but recently, it has also been introduced and used for a vehicle.

Further, in the early stage of using the head-up display in the vehicle, the head-up display mainly displayed gauge board information such as speedometer, fuel gauge, thermometer, etc. of the vehicle, but recently, a head-up display having a function of displaying specific information on a display screen of a navigation by being linked with the navigation assisting in path-finding, or the like through map guide has also been introduced.

The driver driving the vehicle needs to drive while keeping eyes forward through a windshield of the vehicle in order to safely drive the vehicle, however, the gauge board or the navigation is located at a position deviating from the forward view of the driver, that is, below the forward view, at the right or left side of the forward view, etc., therefore, when there is a need to check the gauge board or the navigation while driving, the driver may not keep eyes forward since the gauge board and the navigation are deviated from the forward view that is a main view and located below the forward view or at the right or left side of the forward view, such that there is a possibility of an accident with an increased risk.

In order to prevent the risk in advance, the head-up display is located within the main view of the front of the driver and linked with the gauge board and/or the navigation by various methods known in the art, thereby visually providing all or some of information displayed by the gauge board and/or the navigation to the driver.

As the head-up display having the functions described above, there is a technology disclosed in Patent Document 1. FIG. 1 is a perspective view illustrating a schematic configuration of a conventional head-up display described in Patent Document 1.

As illustrated in FIG. 1, the head-up display 1 of the Patent Document 1 includes a projection screen 3, a carrier 2 and/or a holder 4, and a base 5 detachably connected to the carrier 2 and/or the holder 4, and the projection screen 3 is mechanically connected to the base 5, such that a portion between the holder 4 and the carrier 2 may be easily separated and detached therefrom. Thereby, it is possible to easily separate the projection screen 3 from the head-up display 1 to be replaced.

Meanwhile, the head-up display may be directly attached to a vehicle at the time of manufacturing the vehicle by a manufacturer to supply to consumers. However, recently, the head-up display is manufactured separately from the vehicle and supplied to the consumers via a separate distribution channel different from that of the vehicle, and the consumers generally mount the head-up display purchased via the separate distribution channel on an upper end of a dashboard in front of a driver's seat of a vehicle and use it.

### [Prior Art Document]

### [Patent Document]

[Patent Document 1] Korean Patent Laid-Open Publication No. 10-2013-79543 (laid-open on July 10, 2013)

### [Disclosure]

### [Technical Problem]

In a case in which the head-up display is separately manufactured from a vehicle and supplied via a separate channel different from that of the vehicle as described above, the head-up display needs to have a structure which allows a user to easily mount the head-up display in the vehicle in a simple manner.

To this end, mounting the head-up display on an upper end of the dashboard of the vehicle using an adhesive is the easiest way. However, the upper end of the dashboard of the vehicle may have a curved surface shape, or a flat surface shape according to a vehicle model, and in a case of the curved surface shape, a curvature of the curved surface is different from each other according to the vehicle model.

In this case, since severe vibration may be applied to a vehicle while running on a road according to conditions of the road, the head-up display needs to be firmly mounted on a mounting portion so that the head-up display may withstand the vibration.

Further, in order to effectively use the head-up display, it is preferable that a display unit of the head-up display is located to be in line with gaze of a driver toward the front. However, physical conditions including a height of the driver is different for each person, and even if the physical conditions of every driver are the same as each other, driving habit is different for each person. In addition, once the head-up display is mounted and fixed on the dashboard of the driver's seat, the position of the head-up display may not be moved. To solve such problems, it is preferable that an angle of the display unit of the head-up display may be adjusted depending on the physical condition and the driving habit of each driver, such that the display unit may be located to be in line with the gaze toward the front at the time of driving.

However, in the conventional head-up display of Patent Document 1, a mounting unit for mounting the head-up display depending on the shape of the dashboard of the vehicle is not substantially described. Further, since an angle of the projection screen that is a display unit is also fixed, there is no means that may adjust the angle to cope with various situations.

In consideration of the above-mentioned circumstances in the art, it is an object of the present invention to provide a head-up display capable of being firmly mounted regardless of a shape of a dashboard of a vehicle that is different for each vehicle model, and easily adjusting an angle of a display unit of the head-up display according to a physical condition and driving habit of a driver to allow a position of the display unit to be in line with gaze toward the front at the time of driving as much as possible.

### [Technical Solution]

In order to accomplish the above objects, there is provided a head-up display which displays operation information of a transportation means, including: a main body; a display means which is pivotally connected with the main body and is configured to display the operation information as an image; and a mounting means configured to mount the main body in the transportation means.

Preferably, the display means is pivotally connected with the main body by a hinge unit.

In addition, the hinge unit may include a cylindrical guide fixedly installed in a neck portion extending from one side of the display means; and a pivot axis having one portion fixed to the main body, and the other portion inserted into in the cylindrical guide so as to allow the display means to pivot.

Further, the cylindrical guide may be made of a material having elasticity.

Further, the mounting means may include an elastic plate which is coupled to a back surface of the main body at a predetermined interval, and is made of a material having an elastic restoring force; an adhesive layer which is adhered on a back surface of the elastic plate, and is made of a material having an elasticity and containing an adhesive material; and a release paper attached to a back surface of the adhesive layer.

Furthermore, the display means may be a transparent organic light-emitting display.

### [Advantageous Effects]

According to the head-up display of the present invention having the above-described configuration, an angle of the display unit may be freely adjusted so that a position of the display unit is within a range of forward view of a driver.

In addition, since the elastic plate and the adhesive layer of the mounting means are made of a material having an elastic restoring force, the head-up display may be firmly mounted in both of a case in which the mounting portion has a curved surface shape and a case in which the mounting portion has a flat surface shape, and may be firmly mounted even in a transportation means having various curvatures regardless of difference between curvatures of the mounting portion.

Further, the cylindrical guide of the hinge uses elastic materials such as rubber, urethane, etc., thus a stop position of the display means may be fixed to an accurate position at the time of rotation thereof.

### [Description of Drawings]

FIG. 1 is a perspective view illustrating a schematic configuration of a conventional head-up display;
FIG. 2 is a perspective view illustrating a schematic configuration of a head-up display according to a preferred embodiment of the present invention;
FIG. 3 is a cross-sectional view illustrating a configuration of a hinge unit of the head-up display according to the preferred embodiment of the present invention;
FIG. 4 is an exploded perspective view illustrating a configuration of a mounting unit of the head-up display according to the preferred embodiment of the present invention; and
FIG. 5 is a diagram illustrating use in a state in which a display unit of the head-up display according to the preferred embodiment of the present invention is completed folded

### [Best Mode]

Hereinafter, a head-up display 100 according to a preferred embodiment of the present invention will be described in detail with reference to the accompanying drawings.

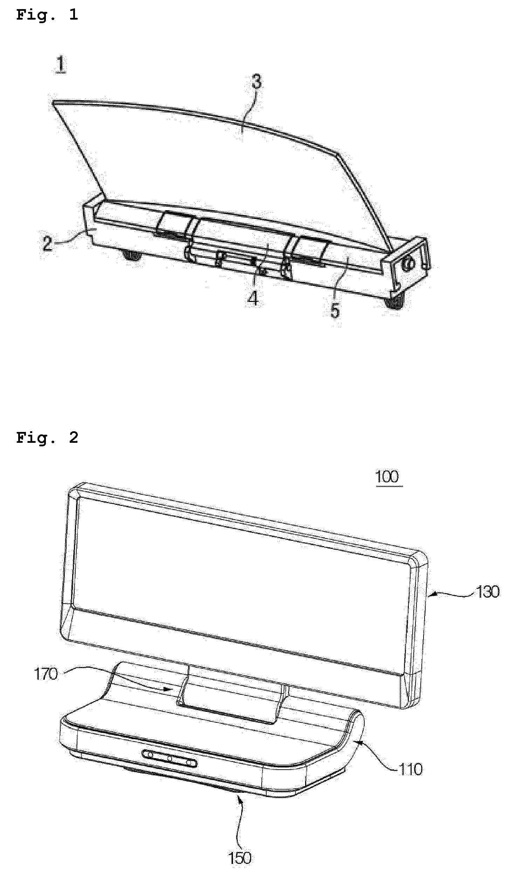

First, as illustrated in FIG. 2, the head-up display 100 according to the present embodiment includes a main body 110, a display unit 130 displaying operation information of a vehicle as an image, and a mounting unit 150 for mounting and fixing the head-up display 100 on a mounting portion such as a dashboard of the vehicle. The display unit 130 is connected with the main body 110 by a hinge unit 170 while an angle between the display unit 130 and the main body 110 is adjustable.

The main body 110 has an appropriate shape such as a rectangular parallelepiped shape, etc., and accommodates various electrical and electronic components required to display the operation information of the vehicle as an image therein.

The display unit 130 displays the operation information of the vehicle as an image such that a driver may visually recognize the operation information of the vehicle, and may include any one of display devices such as a cathode-ray tube (CRT), a liquid crystal display (LCD), an organic light-emitting display (OLED), etc. Considering a fact that the head-up display according to the present invention is disposed within forward view of the driver, it is preferred to use a transparent organic light-emitting display (TOLED) so as not to block the forward view of the driver.

In the present disclosure, the term "operation information" refers to information provided by a transportation means itself, for example, a driving speed, an amount of fuel, and an engine temperature of various transportation means such as a vehicle, an aircraft, a ship, or the like in which the head-up display of the present invention is used. The operation information means all of various information generally displayed on a gauge board of the transportation means and information provided by a navigation, for example, the driving speed, a destination, and various information generated on the way to the destination such as various information provided by the navigation, for example, various route information including a remaining distance, positions of intersections, tunnels, or bridges, intersection information, etc., various warning signals for safe driving, and the like.

The display unit 130 is pivotally connected with the main body 110 by the hinge unit 170, in other words, is connected with the main body 110 so that an angle between the main body 110 and the display unit 130 is adjustable.

Further, although not illustrated in the drawings, the display unit 130 may also include, for example, a camera module including a camera such as a black box, for imaging an external image, and a speaker including a microphone for voice support, respectively.

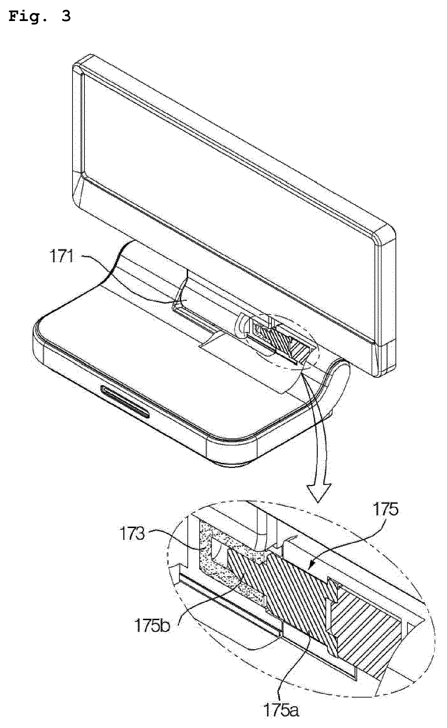

Next, the hinge unit 170 will be described in detail with reference to FIG. 3.

The hinge unit 170 is disposed between one side surface of the main body 110 in a longitudinal direction thereof and one side surface of the display unit 130 in a longitudinal direction thereof, so that the display unit 130 is pivotally connected with the main body 110.

The hinge unit 170 includes: a neck portion 171 extending from one side surface of the display unit 130, which is pivotally connected with the main body 110, in the longitudinal direction thereof toward the main body 110; a cylindrical guide 173 fixedly installed in a substantially central portion of the neck portion 171, and made of a material having elasticity such as rubber or urethane; and a pivot axis 175 including a small diameter portion 175b inserted into the cylindrical guide 173 so as to allow the display unit to pivot, and a large diameter portion 175a having relatively larger diameter than the small diameter portion 175b. The large diameter portion 175a of the pivot axis 175 is fixed to the main body 110.

According to the present embodiment, the large diameter portion 175a of the pivot axis 175 is fixed to the main body 110, and the small diameter portion 175b is inserted into the cylindrical guide 173 fixed to the neck portion 171 of the display unit 130 so as to allow the display unit to pivot, therefore, the driver may hold and pivot the display unit 130 of the head-up display 100 fixedly mounted on the dashboard, or the like of the vehicle with his/her hand, or the like to adjust the angle between the main body 110 and the display unit 130.

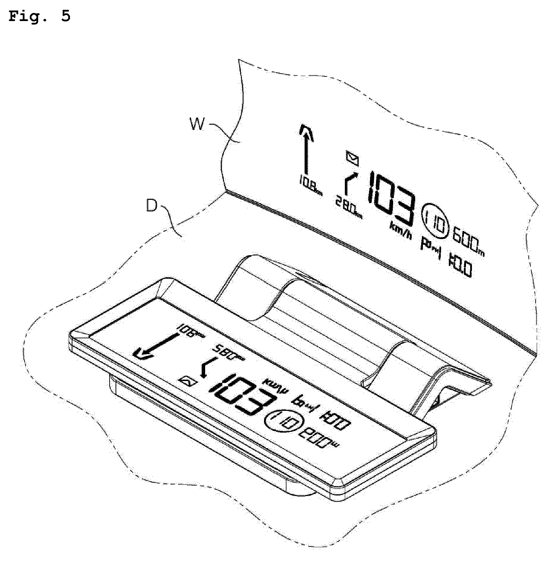

In the head-up display 100 according to the present embodiment, the angle between the main body 110 and the display unit 130 may be adjusted within a range of 0° (a state in which the display unit 130 is completely folded as illustrated in FIG. 5) to 180° (a state in which the display unit 130 is completely unfolded), but the display unit 130 may also be unfolded so that the angle is 180° or more.

According to another embodiment, the head-up display may also have a configuration which further includes an additional pivot axis (not illustrated) located at the hinge unit 170 connected with the display unit 130 so that the display unit 130 is pivotally implemented within an angle of 0° to 360°.

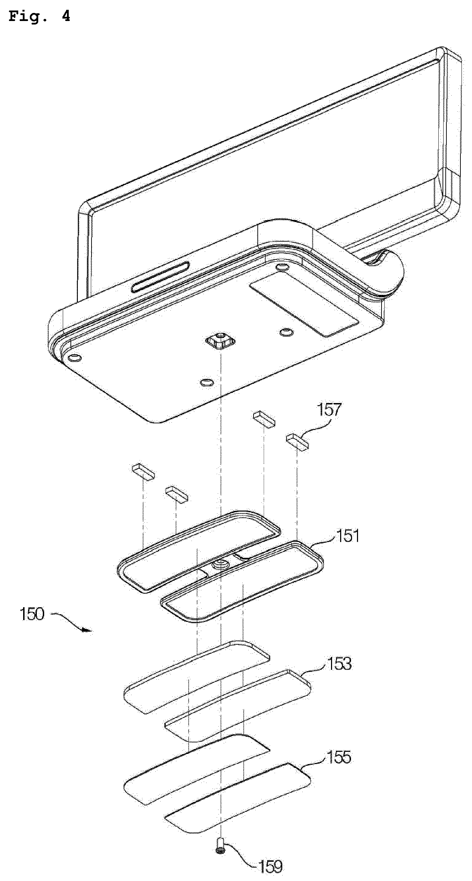

The mounting unit 150 is disposed at a mounting surface (not illustrated) which is a surface of the main body 110 to be mounted on the dashboard of the vehicle, and as illustrated in FIG. 4, includes: an elastic plate 151 formed of a thin plate having a significantly H shape; an adhesive layer 153 adhered on a back surface of the elastic plate 151 and containing an adhesive material such as an adhesive; and a release paper 155 attached to an outer surface of the adhesive layer 153 to protect the adhesive layer 153.

The elastic plate 151 is made of a material having an elastic restoring force, for example, a leaf spring, etc., and has a screw hole formed in a substantially central portion of the H-shaped elastic plate 151, to which a screw is screwed for coupling the mounting unit 150 including the elastic plate 151 to the mounting surface (not illustrated) of the main body 110.

Further, an upper surface of the dashboard of the vehicle on which the head-up display of the present invention is mounted, generally is formed in a curved surface having a predetermined curvature, thus the elastic plate 151 also has an appropriate curvature in accordance with the curvature of the upper surface of the dashboard.

However, the curvature of the upper surface of the vehicle is different from each other for each vehicle model, thus is not uniform, and it is not realistic to separately manufacture the elastic plate 151 of the head-up display of the present invention so that the curvature of the elastic plate 151 is matched with that of each vehicle model. Therefore, according to the present embodiment, the curvature of the elastic plate 151 is matched with the most general curvature of the upper surface of the dashboard of the vehicle, and the elastic plate 151 is made of a material having an elastic restoring force such as a leaf spring such that the curvature may be varied as necessary.

Further, a surface of the elastic plate 151 to which the adhesive layer 153 is adhered may have a concave portion having a shape corresponding to the shape of the adhesive layer 153, in order to easily accommodate the adhesive layer 153.

In addition, it is preferable that the elastic plate 151 is coupled to the mounting surface (not illustrated) of the main body 110 by the screw at a predetermined interval, and to this end, preferably, a groove portion of the central portion of the elastic plate 151, at a side facing the mounting surface (not illustrated) is provided with a protrusion (not illustrated) corresponding to the interval between the mounting surface (not illustrated) of the main body 110 and the elastic plate 151.

The adhesive layer 153 has one surface adhered to one surface of the elastic plate 151, is formed in a shape corresponding to the shape of the elastic plate 151 by using a material having elasticity, for example, sponge, etc. The adhesive layer 153 contains adhesive materials in order to firmly fix and mount the head-up display of the present invention on the upper surface of the dashboard of the vehicle, etc. As the adhesive material, materials known in the art may be used, and as the adhesive layer 153, an adhesive tape containing the adhesive material known in the art, etc. may be used.

The release paper 155 is to protect the adhesive layer 153 during a distribution process or the like of the head-up display of the present invention, and is a typical release paper known in the art that is attached to the outer surface of the adhesive layer 153. When mounting the head-up display on the dashboard of the vehicle, or the like, the release paper 155 is separated from the adhesive layer 153 and then the adhesive layer 153 of the mounting unit 150 is mounted on the upper surface of the dashboard while being pressed by a user.

The elastic pate 151 having the adhesive layer 153 and the release paper 155 adhere thereto is fixed to the mounding surface (not illustrated) of the main body 110 a screw 159 to be screwed to the screw hole.

Further, as illustrated in FIG. 4, it is preferable that cushion materials 157 (e.g. sponge, etc.) having elasticity and a thickness corresponding to the interval between the elastic plate 151 and the mounting surface (not illustrated) are inserted into the interval therebetween. According to the present embodiment, the cushion materials 157 are disposed at four places, but the number of cushion materials 157 may be varied as necessary.

Next, a method for mounting the head-up display 100 of the present embodiment on the upper surface of the dashboard of the vehicle, etc., and an effect resulting from the mounting unit 150 having the configuration according to the present invention will be described with reference to FIGS. 4 and 5.

Before mounting the head-up display 100, first, the release paper 155 of the mounting unit 150 is separated to expose the adhesive layer 153 to an outside, and the adhesive layer 153 of the head-up display 100 is pressed, while applying a force thereto by the user, to the mounting portion, for example, the upper surface of the dashboard D on the gauge board of the vehicle.

In this case, the elastic plate 151 of the mounting unit 150 has a predetermined curvature, and both of the adhesive layer 153 and the elastic plate 151 are made of the materials having elasticity. Therefore, the adhesive layer 153 and the elastic plate 151 are deformed depending on the curvature of the upper surface of the dashboard D and accurately and firmly mounted on the mounting portion, when the upper surface of the dashboard D is a curved surface and the curvature of the upper surface of the dashboard D corresponds to the curvature of the elastic plate 151, and even when the curvature of the upper surface of the dashboard does not correspond to the curvature of the elastic plate 151.

Further, even when the upper surface of the dashboard D is a flat surface unlike the curved surface, the adhesive layer 153 and the elastic plate 151 are deformed into a flat surface shape by forcedly applying force to the head-up display 100 and pressing so as to completely contact the upper surface of the dashboard D that is a flat surface, and accurately and firmly mounted on the mounting portion.

In addition, since a predetermined interval is formed between the elastic plate 151 and the mounting surface (not illustrated) of the main body 110, and the cushion materials 157 are disposed in the interval, it is possible to secure a space required for deformation of the adhesive layer 153 and the elastic plate 151 when these parts are deformed depending on the curvature of the upper surface of the dashboard D, and direct contact between the elastic plate 151 and the mounting surface (not illustrated) is prevented by the cushion materials 157 disposed in the interval with being pressed.

A mounting position of the head-up display 100 is not particularly limited, but considering a basic object of using the head-up display of the present invention, it is preferable that the head-up display 100 is mounted within a range of forward view of the driver, particularly, on an axis corresponding to an axis of gaze of the driver driving the vehicle.

Next, a method for adjusting the angle between the main body 110 and the display unit 130 in a state in which the head-up display 100 of the present embodiment is mounted will be described.

As described above, the display unit 130 is pivotally connected with the main body 110 by the hinge unit 170, thus the angle between the main body 110 and the display unit 130 is adjusted by pivoting the display unit 130 using, for example, a hand in a direction close to or apart from the main body 110. Therefore, the driver pivots the display unit 130 of the head-up display 100 forward or backward while keeping eyes forward in a state of seating on the driver's seat, thereby adjusting the angle to an angle at which a display screen of the display unit 130 is most clearly visible within a range of main view at the time of driving, in other words, an angle at which the display screen of the display unit 130 of the head-up display 100 is clearly visible without moving gaze toward the front while keeping eyes on the front at the time of driving.

FIG. 5 illustrates a state in which the display unit 130 is completely folded such that the angle between the main body 110 and the display unit 130 is 0°, and in the state in which the display unit 130 is folded as illustrated in FIG. 5, an image displayed on the back surface of the display unit 130 may be projected on a windshield W of the vehicle so that the driver may view the projected image.

In this case, the hinge unit 170 of the present embodiment has an advantage that the cylindrical guide 173 is made of elastic materials such as rubber, urethane, etc., and the small diameter portion 175b of the pivot axis 175 is inserted into the cylindrical guide 173 having elasticity without a gap, therefore, when stopping the rotation between the display unit 130 and the main body 110, the pivoting of the display unit is exactly stopped at a desired position by the elastic restoring force of the guide.

While the preferred embodiments of the present invention have been described, but the present invention is not limited to the above embodiments, and may be variously changed and modified within a scope of the technical idea of the present invention.

In the embodiments described above, a case in which the head-up display of the present invention is used in a vehicle has been described, but the head-up display of the present invention is not limited to be used for a vehicle, but may also be used for various transportation means such as an aircraft, a ship, or the like. When the head-up display of the present invention is used in a ship, an aircraft, or the like, the head-up display may be mounted and used at an appropriate place within a range of forward view of a person who uses the corresponding head-up display.

Further, in the embodiments described above, a case in which the head-up display of the present invention is mounted on the upper end of the dashboard on the gauge board has been described, but this is merely a preferred example of a mounting position on the basis of the basic object of the head-up display of the present invention, and the mounting position may be varied depending on a purpose of use.

Further, in the embodiments described above, a case in which the main body and the display unit are pivotally connected by the hinge unit having a specific structure has been described, but the structure of the hinge unit is not limited to the embodiment, and any known structure may be used so long as the angle between the display unit 130 and the main body 110 may be changed by pivoting the display unit 130 in relation to the main body 110.

Further, in the embodiments described above, a case in which the elastic plate 151 of the mounting unit 150 has an H-letter shape has been described, but the present invention is not limited thereto. The elastic plate 151 may have any shape so long as it is a structure in which the main body 110 may be firmly mounted on the mounting portion. For example, various shapes such as a Z shape, N shape, M shape, or the like may be possible.

Further, in the embodiments described above, as the material of the adhesive layer 153 and the cushion material 157, a sponge is used, but the present invention is not limited thereto. Any material having an elastic restoring force may be used.

Further, in the embodiments described above, a case in which the pivot axis 175 of the mounting unit 150 includes the large diameter portion and the small diameter portion having diameters different from each other, and the small diameter portion is installed in the cylindrical guide, has been described, but the present invention is not limited thereto. For example, the diameter of the pivot axis may be uniform, one portion of the pivot axis may be fixed to the main body, and the other portion thereof may be pivotally installed in the cylindrical guide.

Further, in the embodiments described above, as a head-up display using a communication terminal and Bluetooth communication to extract location information, operation information, distance information, traffic information, or the like from a program driven in the communication terminal, a head-up display including: a display means displaying information as an image;
a linking means performing linking so that the information may be extracted and displayed on the display means as an image; and a control means controlling the communication terminal and Bluetooth communication, may be implemented.

Further, in the embodiments described above, a head-up display including a voice processing means outputting a voice signal transmitted in the communication terminal and Bluetooth communication as a voice may be implemented.

Further, in the embodiments described above, a head-up display including a microphone generating a voice signal and a speaker outputting the voice signal as a voice may be implemented.

Further, in the embodiments described above, a head-up display, which includes a power unit for supplying power to drive the display means, the linking means, and the power unit includes a solar cell, may be implemented.

### [Description of Reference Numerals]

100: head-up display
110: main body
130: display unit
150: mounting unit
151: elastic plate
153: adhesive layer
155: release paper
170: hinge unit
171: neck portion
173: guide
175: pivot axis

## Claims

1. A head-up display which displays operation information of a transportation means, comprising:
a main body;
a display means which is pivotally connected with the main body and is configured to display the operation information as an image; and
a mounting means configured to mount the main body in the transportation means.

2. The head-up display according to claim 1, wherein the display means is pivotally connected with the main body by a hinge unit.

3. The head-up display according to claim 2, wherein the hinge unit includes a cylindrical guide fixedly installed in a neck portion extending from one side of the display means; and
a pivot axis having one portion fixed to the main body, and the other portion inserted into in the cylindrical guide so as to allow the display means to pivot.

4. The head-up display according to claim 3, wherein the cylindrical guide is made of a material having elasticity.

5. The head-up display according to claim 1, wherein the mounting means includes an elastic plate which is coupled to a back surface of the main body at a predetermined interval, and is made of a material having an elastic restoring force;
an adhesive layer which is adhered on a back surface of the elastic plate, and is made of a material having an elasticity and containing an adhesive material; and
a release paper attached to a back surface of the adhesive layer.

6. The head-up display according to claim 1, wherein the display means is a transparent organic light-emitting display.
